# EUROPEAN PATENT APPLICATION

(11) **EP 2 767 612 A1**
(43) Date of publication of application: **20.08.2014**
(21) Application number: 12840633.7
(22) Date of filing: 12.10.2012
(51) Int. Cl.: C23C 16/458, H01L 21/205

(54) **CVD DEVICE, METHOD FOR MANUFACTURING SUSCEPTOR IN WHICH CVD DEVICE IS USED, AND SUSCEPTOR**

(30) Priority: 14.10.2011 JP 2011226577
(71) Applicant: Toyo Tanso Co., Ltd., Osaka-shi, Osaka 555-0011 (JP)
(72) Inventor: KITA, Masaaki, Kanonji-shi Kagawa 769-1612 (JP); KUBOTA, Takeshi, Kanonji-shi Kagawa 769-1612 (JP); HIRANO, Hiroyuki, Kanonji-shi Kagawa 769-1612 (JP)
(74) Representative: Glawe, Delfs, Moll
(86) International application number: PCT/JP2012/076423
(87) International publication number: WO 2013/054876

(57) **Abstract**

The invention provides a CVD apparatus that can remarkably improve the quality and productivity of a susceptor provided with a film such as a SiC film or a TaC film without causing increase in production cost or increase in size of the apparatus. The invention also provides a method of manufacturing a susceptor using the CVD apparatus and a susceptor.

A masking portion (recessed portion) 20 is provided at the center of a rear surface of a carbonaceous substrate 10. The masking portion 20 includes a first bore portion 20a and a second bore portion 20b. The first bore portion 20a has an inner wall in which a female screw portion 21 is formed. A male screw portion 7a of a masking jig 7 is screw-fitted to the female screw portion 21. The masking jig 7 is fixed to a film forming jig 2. The carbonaceous substrate is thus supported in a standing posture, and the carbonaceous substrate is provided, on a surface, with a film such as a SiC film or a TaC film except for the recessed portion by introducing gas into the apparatus in this supported state.

## Description

### TECHNICAL FIELD

The present invention relates to a CVD apparatus for forming a film such as a SiC film or a TaC film on an entire surface of a carbonaceous substrate, a method of manufacturing a susceptor using the CVD apparatus, and a susceptor fabricated by this manufacturing method.

### BACKGROUND ART

A susceptor used for semiconductor epitaxial growth, for example, is made of a material in which a coating layer of a SiC, a TaC, or the like is formed on a surface of a carbonaceous substrate. For example, the formation of the SiC film on the carbonaceous substrate surface is usually carried out by a CVD (chemical vapor deposition) technique, in which SiC is deposited on the carbonaceous substrate surface directly by causing a halogenated organic silicon compound containing a carbon source, such as hydrocarbon, to undergo a thermal decomposition reaction in a reductive gas flow. The formed SiC film needs to be formed in an extremely dense and uniform layer without any pin hole, in order to cover the entire surface of the carbonaceous substrate.

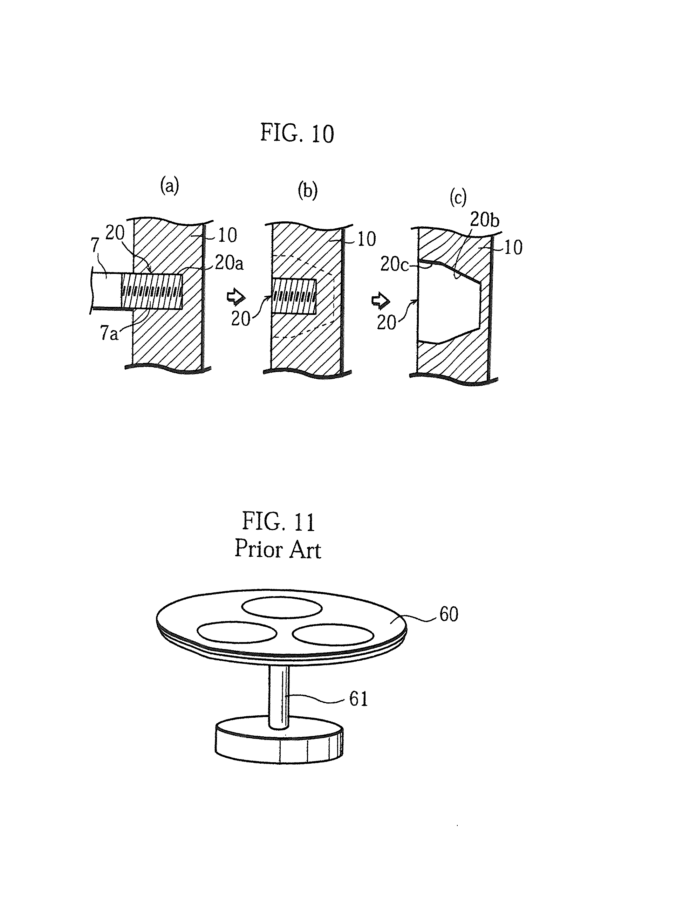

For a susceptor in which a mask portion is provided, the formation of the SiC film has been carried out in such a condition that, as illustrated in Fig. 11 a carbonaceous substrate 60 is oriented horizontally (i.e., laid down horizontally) while supporting the carbonaceous substrate 60 by a masking member 61. This method, however, has the following problems.

When the carbonaceous substrate 60 is oriented horizontally in carrying out the film formation, the SiC film is formed in such a condition that particles such as contaminants and peeled fragments exist on the recessed surface of the carbonaceous substrate 60. If the formation of the SiC film is carried out using the susceptor in such a condition, the wafer accommodated in the recess moves within the recessed surface and comes into contact with the side face of the recessed portion due to the adverse effect of the particles. As a consequence, chipping or cracking occurs in the wafer. In the worst case, for example, the problem arises that the wafer comes out of the recess. Another problem has been that color unevenness occurs because of unevenness in the film thickness.

In view of such circumstances, it has been proposed to shift the supporting contact points for the carbonaceous substrate successively by suspending the carbonaceous substrate on a rotation support rod having a cross section smaller than the diameter of the through hole of the carbonaceous substrate (see Patent Document 1 listed below). Such a proposal can solve the foregoing problem. However, the proposal shown in Patent Document 1 can be applied only to the susceptor having a hole. Moreover, it requires additional drive means, for example, for operating the rotation support rod, leading to other problems such as increase in production cost of the CVD apparatus and increase in size of the CVD apparatus.

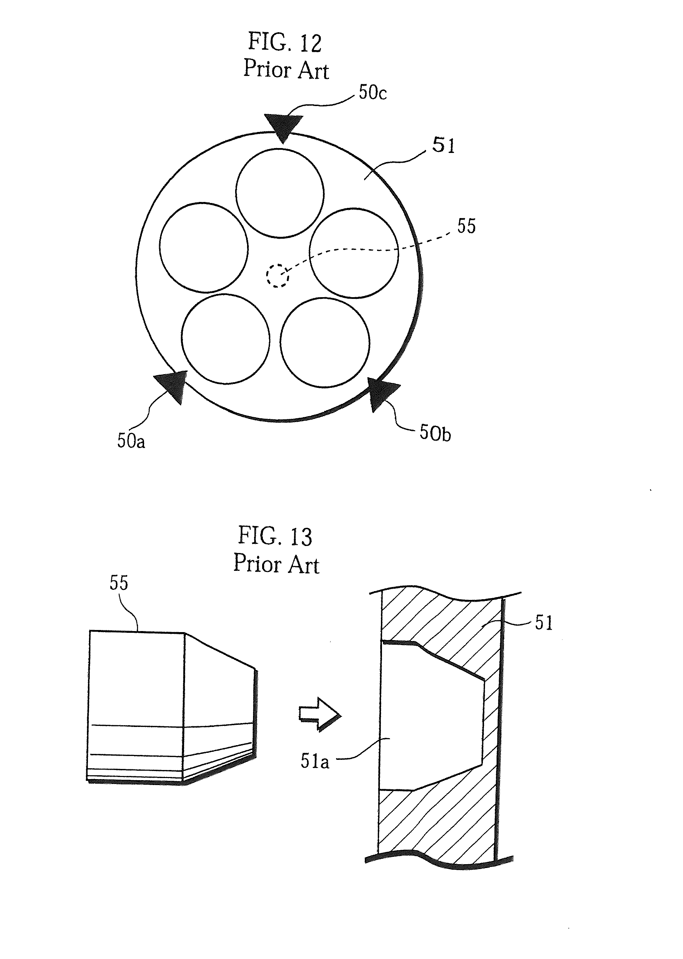

In view of this, a susceptor freestanding-type CVD apparatus as illustrated in Figs. 12 and 13 has been proposed. Specifically, in the CVD apparatus, a carbonaceous substrate 51 having a masking member 55 attached thereto is supported at three points, namely, lower support pieces 50a and 50b and an upper support piece 50c. Such a structure can be applied to even susceptors with no hole. Moreover, it eliminates the need of drive means for operating the rotation support rod. As a result, it is possible to prevent increase in production cost of the CVD apparatus and increase in size of the CVD apparatus.

### CITATION LIST

### [PATENT DOCUMENT]

[Patent Document 1]
Japanese Published Unexamined Patent Application No. S63(1988)-134663 A

### SUMMARY OF THE INVENTION

### PROBLEMS TO BE SOLVED BY THE INVENTION

However, the conventional structure described above requires carrying out film formation processing twice. In addition, since the masking member 55 is merely placed into the recessed portion 51a of the carbonaceous substrate 51 (see Fig. 13), the carbonaceous substrate 51 may fall off when an external force is applied thereto. Moreover, since the support point marks are formed in the outer peripheral portion of the susceptor, cracking can occur in the outer peripheral portion of the susceptor. These problems lead to deterioration in quality and productivity of the susceptor.

In view of the foregoing circumstances, it is an object of the present invention to provide a CVD apparatus that can remarkably improve the quality and productivity of susceptors without causing increase in production cost or increase in size of the apparatus, a method of manufacturing a susceptor using the CVD apparatus, and a susceptor.

### MEANS FOR SOLVING THE PROBLEMS

In order to accomplish the foregoing object, the present invention provides a CVD apparatus for forming a film on a surface of a carbonaceous substrate, wherein the carbonaceous substrate partially has at least one recessed portion provided with an engaged portion, the carbonaceous substrate is supported in a standing posture by engagement support means including an engaging portion to be engaged with the engaged portion, and the film is formed on the surface of the carbonaceous substrate except for the recessed portion by introducing gas into the apparatus in the supported state.

In the structure in which the engaging portion is engaged with the engaged portion to support the carbonaceous substrate. The carbonaceous substrate is thus supported firmly by the engagement support means. It is possible to prevent the carbonaceous substrate from falling off during film formation even if external force such as vibration is applied.

Moreover, this apparatus does not have the structure in which the carbonaceous substrate is supported at its outer periphery. Therefore, the support point marks are not formed in the outer peripheral portion of the susceptor, and as a result, cracking in the outer peripheral portion of the susceptor can be prevented.

In addition, since the carbonaceous substrate is supported in the standing posture, particles are inhibited from building up in the recess. As a result, the wafer is inhibited from chipping or cracking and the wafer is prevented from coming out of the recess when semiconductor epitaxial growth is conducted using the susceptor. In addition, the susceptor is inhibited from generating warpage resulting from the weight of the carbonaceous substrate itself.

Accordingly, the susceptor fabricated by the CVD apparatus according to the present invention shows a less amount of warpage and a smaller percentage of occurrence of cracking and color unevenness, resulting in good outer appearance. Thus, the quality of the susceptor can be improved.

Moreover, since the CVD apparatus according to the present invention does not require additional drive means such as the rotation support rod. As a result, the increase in production cost of CVD apparatus and the increase in size of the CVD apparatus can be prevented.

In the present invention, preferably, the engaged portion is a female screw portion formed in an inner wall of the recessed portion, and the engaging portion is a male screw portion to be screw-fitted to the female screw portion.

When the screw is employed as the engaging means, the carbonaceous substrate is fixed more firmly by the engagement support means. It is thus possible to perfectly prevent the carbonaceous substrate from falling off.

In the present invention, preferably, the recessed portion is a masking portion having an inner wall provided with the female screw portion, the engagement support means includes a masking jig having an outer peripheral surface provided with the male screw portion and a film forming jig for fixing the masking jig, and when the male screw portion is screw-fitted to the female screw portion and the masking jig is fixed to the film forming jig, the carbonaceous substrate is supported in the standing posture.

When the masking recessed portion, the masking jig, and the film forming jig are used as in the configuration described above, it is possible to achieve reduction in production cost for the CVD apparatus and prevention of the increase in size of the CVD apparatus with no need to provide any dedicated member or mechanism.

In the present invention, preferably, the at least one recessed portion provided with the engaged portion includes two recessed portions, a first one of the two recessed portions is engaged with the engaging portion of the engagement support means and first film formation processing is carried out to form a film on the surface of the carbonaceous substrate except for the first recessed portion, and a second one of the two recessed portions is engaged with the engaging portion of the engagement support means and second film formation processing is carried out to form a film on the surface of the carbonaceous substrate except for the second recessed portion.

The above configuration achieves the susceptor provided with no masking portion and improved in quality.

Furthermore, the present invention provides a method of manufacturing a susceptor by forming a film on a surface of a carbonaceous substrate, the method including the steps of: preparing the carbonaceous substrate having at least one recessed portion provided with an engaged portion and engagement support means having an engaging portion engageable with the engaged portion; and carrying out film formation processing of engaging the engaged portion of the carbonaceous substrate with the engaging portion of the engagement support means to support the carbonaceous substrate in a standing posture, and forming the film on the surface of the carbonaceous substrate except for the recessed portion by introducing gas in the supported state.

The above configuration achieves fabrication of the susceptor improved in quality and provided with the masking portion, by carrying out film formation processing once.

In the present invention, preferably, the carbonaceous substrate includes the at least one recessed portion provided with the engaged portion includes two recessed portions, in the step of film formation processing, a first one of the two recessed portions is engaged with the engaging portion of the engagement support means and first film formation processing is carried out to form a film on the surface of the carbonaceous substrate except for the first recessed portion, and a second one of the two recessed portions is engaged with the engaging portion of the engagement support means and second film formation processing is carried out to form a film on the surface of the carbonaceous substrate except for the second recessed portion.

The above configuration achieves fabrication of the susceptor improved in quality and provided with no masking portion, although film formation processing needs to be carried out twice.

In the present invention, the method preferably includes, after the step of film formation processing, the step of cutting off a female screw portion provided at the recessed portion.

The present invention provides a susceptor including a film formed by coating once.

The formation of the film by coating once achieves reduction in cost for the coating and prevention of color unevenness due to coating a plurality of times.

The present invention provides a susceptor having a rear surface provided with a recessed portion.

In the present invention, the recessed portion preferably has an inner wall provided with a female screw portion.

In the present invention, the recessed portion preferably has a flat inner wall provided with no female screw portion.

### ADVANTAGES OF THE INVENTION

The present invention exhibits a significant advantageous effect that it can remarkably improve the quality and productivity of susceptors without causing increase in production cost or increase in size of the apparatus.

### BRIEF DESCRIPTION OF THE DRAWINGS

[Fig. 1] Fig. 1 is a perspective view illustrating the internal structure of a CVD apparatus according to an embodiment 1.
[Fig. 2] Fig. 2 is a plan view illustrating the internal structure of the CVD apparatus according to the embodiment 1.
[Fig. 3] Fig. 3 is a side view illustrating how a carbonaceous substrate is fitted to a film forming jig.
[Fig. 4] Fig. 4 is an enlarged exploded view illustrating a primary portion in Fig. 3.
[Figs. 5(a) to 5(c)] Figs. 5(a) to 5(c) show how the carbonaceous substrate is fitted to the film forming jig, wherein Fig. 5(a) is a perspective view illustrating the state in which a film forming jig, a masking jig, and a carbonaceous substrate are prepared, Fig. 5(b) is a perspective view illustrating how the masking jig is screw-fitted to a mask portion (recessed portion) of the carbonaceous substrate, and Fig. 5(c) is a perspective view illustrating how a screw portion of the masking jig is screw-fitted to a screw hole of a MOCVD screw element.
[Fig. 6] Fig. 6 is a plan view of a carbonaceous substrate used with a CVD apparatus according to an embodiment 2.
[Fig. 7] Fig. 7 is a view illustrating engaging means according to a modified example, for a carbonaceous substrate and a masking jig.
[Fig. 8] Fig. 8 is a view illustrating engaging means according to another modified example, for a carbonaceous substrate and a masking jig.
[Fig. 9] Fig. 9 is a view illustrating engaging means according to yet another modified example, for a carbonaceous substrate and a masking jig.
[Figs. 10(a) to 10(c)] Figs. 10(a) to 10(c) show how a susceptor in which a masking portion is provided is fabricated in accordance with a different example.
[Fig. 11] Fig. 11 is a perspective view illustrating the internal structure of a conventional CVD apparatus.
[Fig. 12] Fig. 12 is a front view illustrating the internal structure of another conventional CVD apparatus.
[Fig. 13] Fig. 13 shows how a masking portion and a masking member are fitted to each other in the conventional CVD apparatus illustrated in Fig. 12.

### BEST MODE FOR CARRYING OUT THE INVENTION

Hereinbelow, embodiments of the present invention will be described. It is noted that the present invention should not be limited to the following embodiments.

### (Embodiment 1)

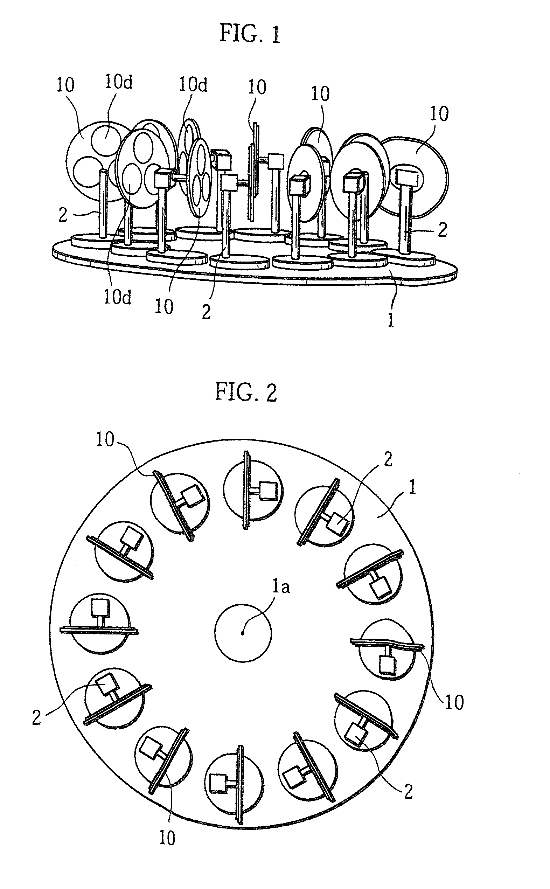

As illustrated in Figs. 1 and 2, a CVD apparatus of the present invention has a disk-shaped rotation table 1 that rotates when forming a SiC film, and a plurality of film forming jigs 2 disposed near the outer periphery of the rotation table 1. It is desirable that these film forming jigs 2 be disposed so as to be equidistant from the center of the apparatus (i.e., the center 1a of the rotation table 1). The reason is as follows. The center of the CVD apparatus and the peripheral portion thereof have different distances from the source gas supply unit. However, when the film forming jigs 2 are disposed so as to be equidistant from the center of the apparatus, the carbonaceous substrates 10 that are attached to the film forming jigs 2 are also disposed so as to be equidistant from the center of the apparatus accordingly. Therefore, the difference in the distance from the source gas supply unit to the carbonaceous substrates 10, which depends on the arrangement positions of the carbonaceous substrates, is eliminated, so the amount of warpage can be reduced in every susceptor. Note that reference numeral 10d in Fig. 1 denotes a recess, and the surface in which the recess 10d is formed is the main surface of the carbonaceous substrate 10.

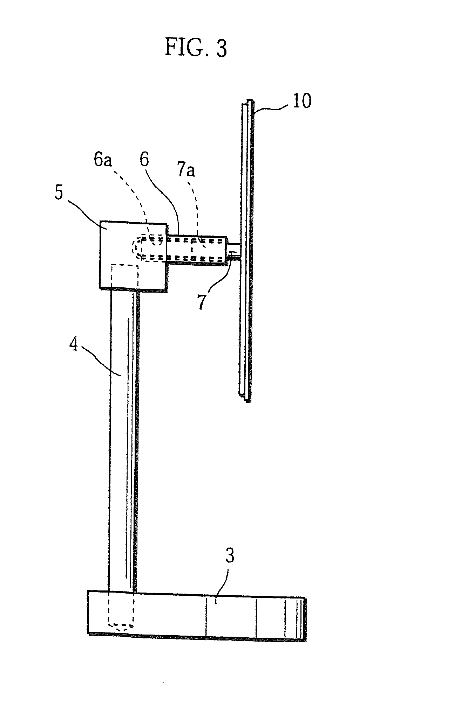

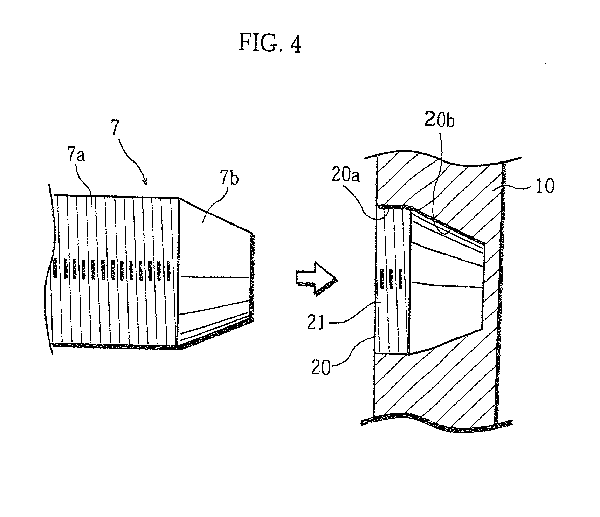

As illustrated in Fig. 3, each of the film forming jigs 2 comprises a pedestal 3, a support rod 4, a MOCVD cubicle 5, and a MOCVD screw element 6. The support rod 4 is fixed near one end of the pedestal 3. The MOCVD cubicle 5 is fixed to the other end of the support rod 4. A male screw portion 7a of a masking jig 7 is screw-fitted to a screw hole 6a formed in the inner periphery of the MOCVD screw element 6. The masking jig 7 has a tip end 7b (right end in Fig. 4) that is formed into a truncated cone shape.

In addition, as shown in Fig. 4, a masking portion (recessed portion) 20 is disposed at the center in a rear surface (left side surface in Fig. 4) of the carbonaceous substrate 10. The masking portion 20 is a recessed portion in a substantially trapezoidal shape, and includes a first bore portion 20a in a circular shape in cross section and a second bore portion 20b in a truncated cone shape in cross section. The first bore portion 20a has an inner wall in which a female screw portion 21 is formed. The male screw portion 7a of the masking jig 7 is screw-fitted to the female screw portion 21. This screw-fitting causes the carbonaceous substrate 10 to be firmly fixed to the masking jig 7. The carbonaceous substrate 10 is thus prevented from falling off during film formation processing. The tip end 7b of the masking jig 7 is fitted into the second bore portion 20b of the masking portion 20. Film formation is thus prevented on the masking portion 20.

Furthermore, the carbonaceous substrate 10 is supported in a standing posture by the masking jig 7 and the film forming jig 2. It is thus possible to inhibit formation of a SiC film in a state in which particles such as contaminants and peeled fragments exist in the recess 10d. Moreover, the male screw portion 7a is screw-fitted to the female screw portion 21, so that the carbonaceous substrate 10 will not fall off and can be supported in a desired posture. For example, the carbonaceous substrate 10 can be arranged such that the main surface provided with the recess 10d is directed downward.

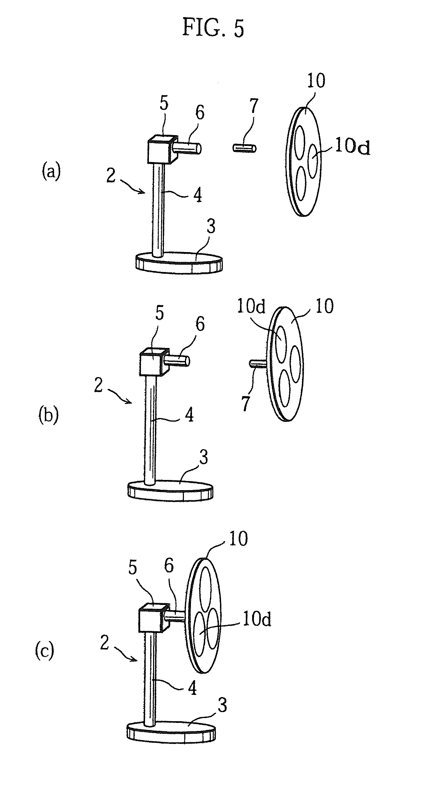

Next, how the carbonaceous substrate 5 is arranged will be described with reference to Figs. 5(a) to 5(c).

First, as illustrated in Fig. 5(a), the film forming jig 2, the masking jig 7, and the carbonaceous substrate 10 are prepared, and thereafter, as illustrated in Fig. 5(b), the tip end 7b of the masking jig 7 is inserted into the masking portion (recessed portion) 20 of the carbonaceous substrate 10 and the male screw portion 7a is screw-fitted to the female screw portion 21. Subsequently, as illustrated in Fig. 5(c), the male screw portion 7a of the masking jig 7 is screw-fitted to the screw hole 6a of the MOCVD screw element 6, and thereafter, a large number of the film forming jigs 2 are disposed in the vicinity of the outer periphery of the rotation table 1, whereby the preparation for the film formation is completed.

Predetermined flow quantity of gas is then flown inward at a predetermined flow rate, and the rotation table 1 is rotated along therewith. Fabricated accordingly is a susceptor in which a SiC film is formed on the surface of the carbonaceous substrate except for a part covered by the masking jig. The female screw portion 21 can be cut off as necessary.

When the carbonaceous substrate 10 has a disk shape, the masking jig 7 is preferably provided at the center of the circle. The masking jig 7 provided at the center of the circle can decrease variation in stress applied to the carbonaceous substrate 10 and reduce warpage and the like of the susceptor.

### (Embodiment 2)

Fabrication of the susceptor provided with the masking portion is described in the above embodiment 1. In contrast, described in this embodiment 2 is fabrication of a susceptor provided with no masking portion.

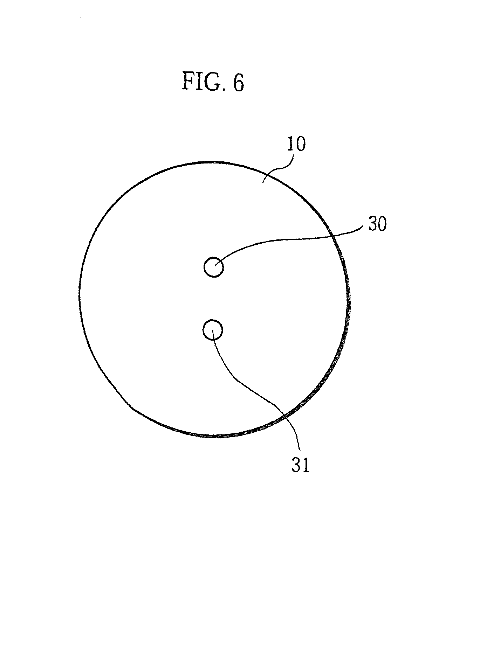

As illustrated in Fig. 6, a carbonaceous substrate 10 used with a CVD apparatus according to this embodiment 2 is provided, in a rear surface, with two recessed portions 30 and 31 that are each configured similarly to the masking portion (recessed portion) 20.

Upon film formation processing, a masking jig 7 is screw-fitted to the recessed portion 30 and is fitted to a film forming jig 2. The carbonaceous substrate 10 is thus supported in a standing posture, in which state the film formation processing is carried out. A SiC film is accordingly formed on the surface except for the recessed portion 30. Subsequently, the masking jig 7 is screw-fitted to the recessed portion 31 and is fitted to the film forming jig 2. The carbonaceous substrate 10 is thus supported in the standing posture, in which state the film formation processing is carried out. A second SiC film is accordingly formed on the surface except for the recessed portion 31. The recessed portion 31 has, however, been already provided with the film by the first SiC film formation processing. Fabricated accordingly is the susceptor in which the SiC film is formed on the entire surface of the carbonaceous substrate 10 by the film formation processing carried out twice.

In this manner, also for the fabrication of the susceptor provided with no masking portion, the SiC film can be formed on the surface of the carbonaceous substrate 10 supported in the standing posture, with gas flown inward. Furthermore, the carbonaceous substrate 10 is supported while being fixed with a screw. Similarly to the above embodiment, the carbonaceous substrate is prevented from falling off during the film formation processing to enable stable film formation.

The masking jig 7 and the film forming jig 2 can be replaced with any other dedicated support fixing jigs.

### (Other Embodiments)

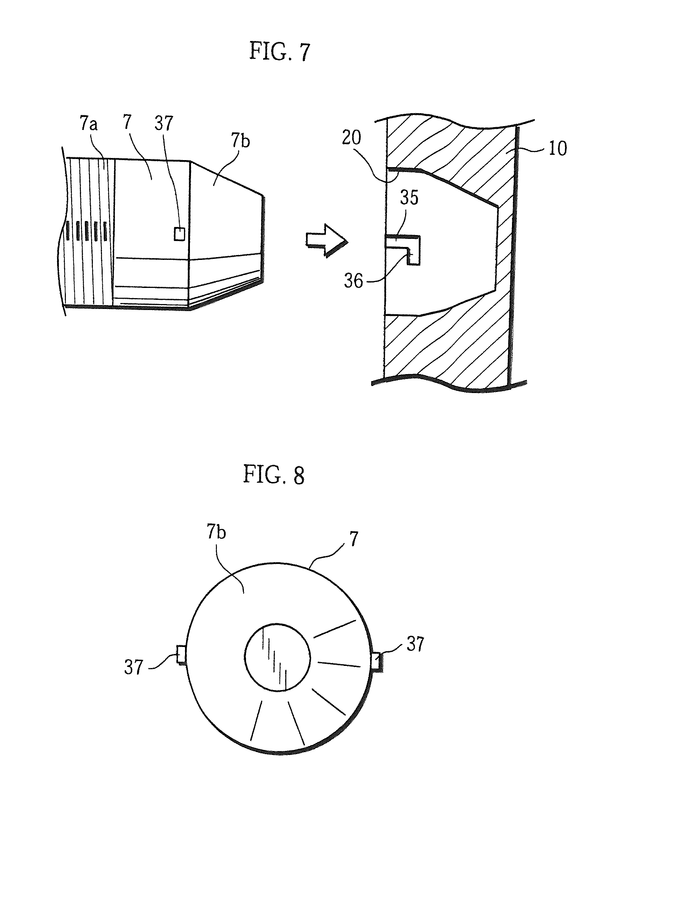

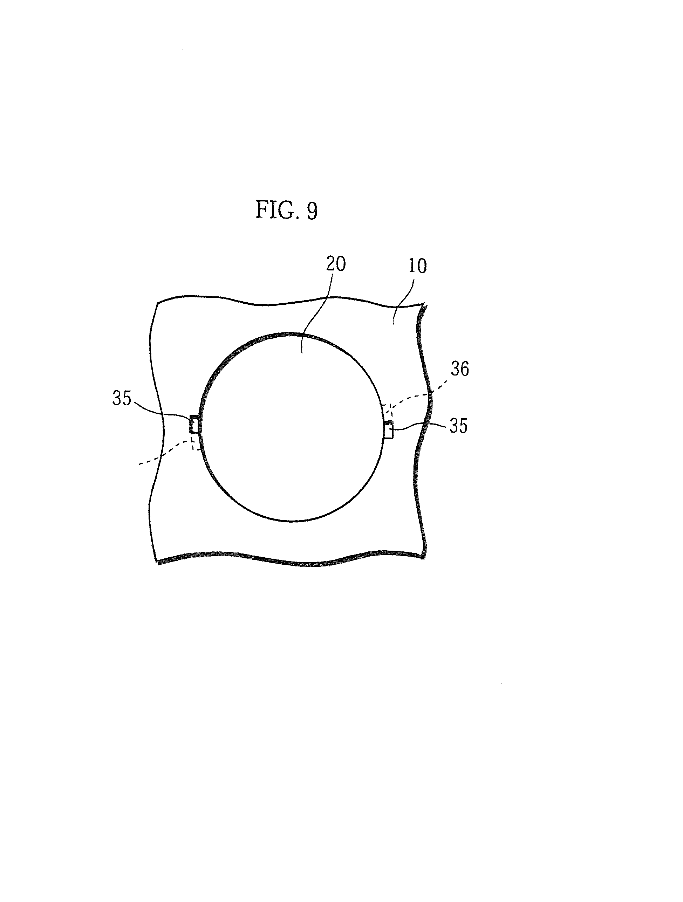

(1) The SiC film is formed on the surface of the carbonaceous substrate 10 in the above embodiments. The present invention is not limited to the SiC film formation but is applicable to formation of a TaC film or any other film.
(2) Screw means is employed as means for fixing the carbonaceous substrate to the masking jig in the above embodiments. The present invention is not limited to this case but can employ any other engaging means. For example, as illustrated in Figs. 7 to 9, the recessed portion 20 in the carbonaceous substrate 10 is provided with a lengthwise groove 35 and a crosswise groove 36, and the masking jig 7 is provided, on the outer peripheral surface of the tip end, with a projection 37. The projection 37 is inserted into the lengthwise groove 35, and the masking jig 7 is then rotated so that the projection 37 is disposed in the crosswise groove 36. The carbonaceous substrate 10 and the masking jig 7 are thus engaged with each other, and the carbonaceous substrate 10 can be supported in the standing posture.
(3) Fabrication of the susceptor provided with the masking portion according to an example is described in the above embodiment 1. The susceptor provided with the masking portion can be fabricated in accordance with another example as illustrated in Figs. 10(a) to 10(c). Specifically, as illustrated in Fig. 10(a), the rear surface of the carbonaceous substrate 10 has a fixing bore 20' provided with an engaged portion 20'a. The engaged portion 20'a is engaged with an engaging portion 7a of a fixing jig 7. Film formation processing is subsequently carried out. After a SiC film is formed on the surface of the carbonaceous substrate 10, a portion indicated by a dotted line in Fig. 10(b) is cut off through machine processing so as to form a masking portion 20 as illustrated in Fig. 10(c). The masking portion 20 is a recessed portion in a substantially trapezoidal shape, and includes a first bore portion 20c in a circular shape in cross section (no female screw portion 21 is formed in the inner wall unlike the first bore portion 20a illustrated in Fig. 4) and a second bore portion 20b in a truncated cone shape in cross section. Such a fabrication method allows a threading portion to be provided for an arbitrary distance within the range of the thickness of the susceptor. The susceptor can be securely fixed to the fixing jig by screwing even in a case where the material for the susceptor has small cohesion or the susceptor has large weight. Moreover, the masking portion can be formed with no thread being left.

### EXAMPLES

Hereinbelow, the present invention will be described in further detail based on examples thereof. However, the CVD apparatus is not limited by the description of the following examples.

### [Example 1]

Using the CVD apparatus according to the embodiment 1 of the present invention, a susceptor was fabricated by forming a film on a carbonaceous substrate in a disk shape having 465 mm in diameter and 16 mm in thickness. The susceptor fabricated in this manner is hereinafter referred to as a present invention susceptor A1. The experiment conditions (film formation conditions) were as follows.

### - Experiment Conditions

Pressure in the apparatus: 0.1 Torr to 760 Torr
Temperature in a furnace: 1150°C to 1500°C
Introduced gas: CH₃SiCl₃ (methyltrichlorosilan) and hydrogen gas as carrier gas
Film thickness of the SiC film: 40 µm to 60 µm

### [Comparative Example 1]

A susceptor was fabricated by the conventional method illustrated in Fig. 12, using a carbonaceous substrate similar to that used in the example 1. Film formation was carried out twice under the same conditions in the example 1. The position of a support point was changed after the first film formation so that a film was formed by the second film formation on a portion where no film was formed due to the support point during the first film formation.

The susceptor fabricated in this manner is hereinafter referred to as a comparative susceptor Z1.

### [Experiment 1]

The states of the film formation, outer appearance, and an amount of warpage were examined on the present invention susceptor A1 and the comparative susceptor Z1. The results are shown in Table 1. In the measurement of the amount of warpage for each of the susceptors, the amount of warpage in the entire susceptor from a center line in a disk flat surface was measured by flatness measurement using a three-dimensional measurement machine.

**TABLE 1**

| Type of susceptor | Method of supporting susceptor | Jig | | Test results | | | |
|---|---|---|---|---|---|---|---|
| | | Upper jig | Lower jig | Amount of warpage (mm) | Outer appearance | Number of film formation | State of carbonaceous substrate |
| Present invention susceptor A1 | Screwing rear masking portion | Support by rear masking | | -0.1 to +0.1 | Good | Once | Not fell off |
| Comparative susceptor Z 1 | Freestanding | One | Two | -0.2 to +0.2 | Slight color unevenness | Twice | Not fell off |

As shown in Table 1, each of the carbonaceous substrates did not fall off when a film was formed on the carbonaceous substrate. It was proved that the film can be formed sufficiently even by carrying out the film formation once. Further reduced is color unevenness due to recoating at the support point. As to warpage occurred during the film formation, the amount of warpage can be reduced by supporting the center of the disk shape.

### INDUSTRIAL APPLICABILITY

The present invention is applied to a CVD apparatus for forming a film such as a SiC film or a TaC film on an entire surface of a carbonaceous substrate, a method of manufacturing a susceptor using the CVD apparatus, and a susceptor fabricated by this film forming method.

### DESCRIPTION OF REFERENCE NUMERALS

- 2: -- Film forming jig
- 7: -- Masking jig
- 7b: -- Male screw portion
- 10: -- Carbonaceous substrate
- 20, 30, 31: -- Recessed portion
- 21: -- Female screw portion

## Claims

1. A CVD apparatus for forming a film on a surface of a carbonaceous substrate, wherein
the carbonaceous substrate partially has at least one recessed portion provided with an engaged portion, the carbonaceous substrate is supported in a standing posture by engagement support means including an engaging portion to be engaged with the engaged portion, and the film is formed on the surface of the carbonaceous substrate except for the recessed portion by introducing gas into the apparatus in the supported state.

2. The CVD apparatus according to claim 1, wherein the engaged portion is a female screw portion formed in an inner wall of the recessed portion, and the engaging portion is a male screw portion to be screw-fitted to the female screw portion.

3. The CVD apparatus according to claim 2, wherein
the recessed portion is a masking portion having an inner wall provided with the female screw portion,
the engagement support means includes a masking jig having an outer peripheral surface provided with the male screw portion and a film forming jig for fixing the masking jig, and
when the male screw portion is screw-fitted to the female screw portion and the masking jig is fixed to the film forming jig, the carbonaceous substrate is supported in the standing posture.

4. The CVD apparatus according to claim 1, wherein
the at least one recessed portion provided with the engaged portion comprises two recessed portions,
a first one of the two recessed portions is engaged with the engaging portion of the engagement support means and first film formation processing is carried out to form a film on the surface of the carbonaceous substrate except for the first recessed portion, and a second one of the two recessed portions is engaged with the engaging portion of the engagement support means and second film formation processing is carried out to form a film on the surface of the carbonaceous substrate except for the second recessed portion.

5. A method of manufacturing a susceptor by forming a film on a surface of a carbonaceous substrate, the method comprising the steps of:
preparing the carbonaceous substrate having at least one recessed portion provided with an engaged portion and engagement support means having an engaging portion engageable with the engaged portion; and
carrying out film formation processing of engaging the engaged portion of the carbonaceous substrate with the engaging portion of the engagement support means to support the carbonaceous substrate in a standing posture, and forming the film on the surface of the carbonaceous substrate except for the recessed portion by introducing gas in the supported state.

6. The method of manufacturing the susceptor according to claim 5, wherein
the carbonaceous substrate includes the at least one recessed portion provided with the engaged portion comprises two recessed portions,
in the step of film formation processing, a first one of the two recessed portions is engaged with the engaging portion of the engagement support means and first film formation processing is carried out to form a film on the surface of the carbonaceous substrate except for the first recessed portion, and a second one of the two recessed portions is engaged with the engaging portion of the engagement support means and second film formation processing is carried out to form a film on the surface of the carbonaceous substrate except for the second recessed portion.

7. The method of manufacturing the susceptor according to claim 5 or 6, the method comprising, after the step of film formation processing, the step of cutting off the engaged portion provided at the recessed portion.

8. A susceptor comprising a film formed by coating once using the CVD apparatus according to any one of claims 1 to 3.

9. A susceptor comprising a film formed by coating once by the manufacturing method according to claim 5.

10. A susceptor having a rear surface provided with a recessed portion.

11. The susceptor according to claim 10, wherein the recessed portion has an inner wall provided with a female screw portion.

12. The susceptor according to claim 10, wherein the recessed portion has a flat inner wall provided with no female screw portion.
